Europäisches Patentamt

European Patent Office

Office européen des brevets

(19)

(11) **EP 0 721 589 B1**

(12) **EUROPÄISCHE PATENTSCHRIFT**

(45) Veröffentlichungstag und Bekanntmachung des Hinweises auf die Patenterteilung:
**04.06.1997 Patentblatt 1997/23**

(21) Anmeldenummer: **94926807.2**

(22) Anmeldetag: **22.09.1994**

(51) Int Cl.$^6$: **G01R 15/24**

(86) Internationale Anmeldenummer:
**PCT/DE94/01104**

(87) Internationale Veröffentlichungsnummer:
**WO 95/10046 (13.04.1995 Gazette 1995/16)**

(54) **VERFAHREN UND VORRICHTUNG ZUM MESSEN EINER ELEKTRISCHEN WECHSELGRÖSSE MIT TEMPERATURKOMPENSATION**

METHOD AND DEVICE FOR MEASURING AN ALTERNATING ELECTRICAL QUANTITY TO INCLUDE TEMPERATURE COMPENSATION

PROCEDE ET DISPOSITIF PERMETTANT DE MESURER UNE GRANDEUR ELECTRIQUE ALTERNATIVE AVEC COMPENSATION DE TEMPERATURE

(84) Benannte Vertragsstaaten:
**AT BE CH DE ES FR GB IT LI NL SE**

(30) Priorität: **01.10.1993 DE 4333467**
**07.07.1994 DE 4423980**
**22.07.1994 DE 4426137**

(43) Veröffentlichungstag der Anmeldung:
**17.07.1996 Patentblatt 1996/29**

(73) Patentinhaber: **SIEMENS AKTIENGESELLSCHAFT**
**80333 München (DE)**

(72) Erfinder:
• **BOSSELMANN, Thomas**
**D-91054 Erlangen (DE)**
• **MENKE, Peter**
**D-91054 Erlangen (DE)**
• **NIEWISCH, Joachim**
**D-90425 Nürnberg (DE)**

(56) Entgegenhaltungen:
**EP-A- 0 088 419     EP-A- 0 108 671**
**US-A- 4 973 899**

**Beschreibung**

Die Erfindung betrifft ein Verfahren und eine Vorrichtung zum Messen einer elektrischen Wechselgröße. Unter einer elektrischen Wechselgröße wird dabei ein elektrischer Wechselstrom, eine elektrische Wechselspannung oder auch ein elektrisches Wechselfeld verstanden.

Es sind optische Meßverfahren und Meßvorrichtungen zum Messen elektrischer Größen wie Strom, Spannung oder Feld bekannt, bei denen die Änderung der Polarisation von polarisiertem Meßlicht in Abhängigkeit von der elektrischen Größe ausgewertet wird. Zum Messen eines elektrischen Stromes wird dabei der magnetooptischen Faraday-Effekt ausgenutzt, zum Messen elektrischer Spannungen und Felder dagegen der elektrooptische Pockels-Effekt.

Unter dem Faraday-Effekt versteht man die Drehung der Polarisationsebene von linear polarisiertem Licht in Abhängigkeit von einem Magnetfeld. Der Drehwinkel ist dabei proportional zum Wegintegral über dem magnetischen Feld entlang des von dem Licht zurückgelegten Weges mit der Verdet-Konstanten als Proportionalitatskonstanten. Die Verdet-Konstante ist abhängig von dem Material, in dem das Licht verläuft, und von der Wellenlänge des Lichts. Zum Messen eines elektrischen Stromes in einem Stromleiter unter Ausnutzung des Faraday-Effekts ist in der Nähe des Stromleiters ein Faraday-Element angeordnet, das aus einem optisch transparenten Material und im allgemeinen aus Glas besteht. Durch das Faraday-Element wird linear polarisiertes Licht geschickt. Das von dem elektrischen Strom erzeugte Magnetfeld bewirkt eine Drehung der Polarisationsebene des Lichtes in dem Faraday-Element um einen Drehwinkel, die von einer Auswerteeinheit als Maß für die Stärke des Magnetfeldes und damit für die Stärke des elektrischen Stromes ausgewertet werden kann. Im allgemeinen umgibt das Faraday-Element den Stromleiter, so daß das polarisierte Licht den Stromleiter in einem quasi geschlossenen Weg umläuft. In diesem Fall ist der Betrag des Polarisationsdrehwinkels in guter Näherung direkt proportional zur Amplitude des Meßstromes.

In einer aus WO 91/01501 bekannten Ausführungsform einer optischen Meßvorrichtung zum Messen eines elektrischen Stromes ist das Faraday-Element als Teil einer optischen Monomode-Faser ausgebildet, die den Stromleiter in Form einer Meßwicklung umgibt. Das polarisierte Meßlicht umläuft den Stromleiter daher bei einem Durchlauf N-mal, wenn N die Anzahl der Windungen der Meßwicklung ist. Beim sogenannten Transmissionstyp durchläuft das Meßlicht die Meßwicklung nur einmal. Beim Reflexionstyp ist dagegen das andere Ende der Faser verspiegelt, so daß das Meßlicht nach einem ersten Durchlauf die Meßwicklung ein zweites Mal in umgekehrter Richtung durchläuft. Wegen der Nicht-Reziprokität des Faraday-Effekts ist deshalb der Drehwinkel beim Reflexionstyp bei gleicher Meßwicklung doppelt so groß wie beim Transmissionstyp.

Aus der EP-B-0 088 419 ist eine optische Meßvorrichtung zum Messen eines Stromes bekannt, bei der das Faraday-Element als massiver Glasring um den Stromleiter ausgebildet ist. Licht einer Lichtquelle wird mit einem Polarisator linear polarisiert und dann in das Faraday-Element eingekoppelt. Das linear polarisierte Licht durchläuft das Faraday-Element einmal und wird dann mit einem Wollaston-Prisma als polarisierendem Strahlteiler in zwei linear polarisierte Lichtteilsignale A und B mit senkrecht zueinander gerichteten Polarisationsebenen geteilt. Jedes dieser beiden Lichtsignale A und B wird über eine zugehörige optische Übertragungsfaser zu einem zugehörigen Lichtdetektor übertragen und in ein entsprechendes elektrisches Signal PA und PB umgewandelt. Aus diesen beiden Signalen PA und PB wird in einer Recheneinheit ein intensitätsnormiertes Meßsignal M = (PA-PB)/(PA+PB) gebildet. Dieses Meßsignal M ist unabhängig von Intensitätsschwankungen der Lichtquelle oder Dämpfungen in den optischen Zuleitungen.

Unter dem elektrooptischen Pockels-Effekt versteht man die Änderung der Polarisation von polarisiertem Meßlicht in einem den Pockels-Effekt aufweisenden Material infolge einer in dem Material induzierten linearen Doppelbrechung, die im wesentlichen über den elektrooptischen Koeffizienten linear abhängig von einem das Material durchdringenden elektrischen Feld ist. Zum Messen eines elektrischen Feldes wird ein Pockels-Element aus einem den Pockels-Effekt zeigenden Material in dem elektrischen Feld angeordnet. Zum Messen einer elektrischen Spannung wird die zu messende Spannung an zwei dem Pockels-Element zugeordnete Elektroden angelegt und das entsprechende, anliegende elektrische Feld gemessen. Durch das Pockels-Element wird polarisiertes Meßlicht gesendet, und die Änderung der Polarisation des polarisierten Meßlichts in Abhängigkeit von der zu messenden Spannung oder dem zu messenden Feld wird mit Hilfe eines Polarisationsanalysators ausgewertet.

Aus der DE-C-34 04 608 ist eine Ausführungsform einer solchen Meßvorrichtung zum Messen der elektrischen Feldstärke bekannt. Eine im zu messenden elektrischen Feld angeordnete Sensoreinrichtung ist über einen ersten Lichtleiter mit einer Lichtquelle und über zwei weitere Lichtleiter mit einer Meßeinrichtung optisch verbunden. Die Sensoreinrichtung besteht aus einer optischen Reihenschaltung einer ersten Linse, eines Polarisators, eines Viertelwellenlängenplättchens ($\lambda$/4-Plättchen), eines Pockels-Elements, eines polarisierenden Strahlteilers als Analysator und außerdem aus zwei dem Analysator zugeordneten weiteren Linsen. Das Licht der Lichtquelle wird über den ersten Lichtleiter und die erste Linse dem Polarisator zugeführt und vom Polarisator linear polarisiert. Das linear polarisierte Licht erfährt sodann in dem $\lambda$/4-Plättchen in einer Komponente eine Phasenverschiebung um $\pi/2$ und wird dadurch zirkular polarisiert. Dieses zirkular polarisierte Licht wird in das Pockels-Element eingekoppelt und durch das elektrische Feld im allgemeinen elliptisch polarisiert. Dieses elliptisch polarisierte Licht wird in dem Analysator in zwei linear polarisierte Lichtteilstrahlen A und B mit im allgemeinen senkrecht zueinander gerichteten Polarisationsebenen aufgespalten. Jedes dieser beiden Lichtteilsignale A und B wird über eine der beiden weiteren Linsen in einen der beiden weiteren Lichtleiter eingekoppelt, zu einem zugehörigen photoelektrischen Wandler in der Meßeinrichtung übertragen und dort jeweils in ein elektrisches Signal PA und PB umgewandelt. Aus den beiden elektrischen Signalen PA und PB wird anschließend von einem Rechner der Meßeinrichtung ein intensitätsnormiertes Meßsignal M = (PA-PB)/(PA+PB) abgeleitet. Dieses intensitätsnormierte Meßsignal M ist zum einen proportional zum Modulationsgrad als Maß für die elektrische Feldstärke und zum anderen weitgehend unabhängig von Intensitätsverlusten auf den Übertragungswegen oder Intensitätsschwankungen der Lichtquelle. Der Modulationsgrad ist dabei als Verhältnis von Signal-Ausgangswert zu Ruhe-Ausgangswert des Pockels-Elements definiert. Als Pockels-Element wird ein Kristall aus $Bi_4Ge_3O_{12}$ oder auch $Bi_4Si_3O_{12}$ mit Eulytin-Struktur verwendet, der keine optische Aktivität (intrinsische zirkuläre Doppelbrechung) zeigt und eine nur relativ schwache Temperaturempfindlichkeit aufweist.

Ein Problem bei allen optischen Meßverfahren und Meßvorrichtungen, bei denen die Polarisationänderung von polarisiertem Meßlicht in einem unter dem Einfluß der Meßgröße stehenden Sensorelement als Meßeffekt ausgenutzt wird, stellen Störeinflüsse durch zusätzliche lineare Doppelbrechung in den optischen Materialien des Sensorelements und der optischen Übertragungsstrecken dar. Solche zusätzliche lineare Doppelbrechung kann durch mechanische Spannungen, die beispielsweise durch Verbiegen oder Vibrationen hervorgerufen werden, oder durch Temperaturänderungen verursacht werden. Diese durch Störgrößen bewirkte, lineare Doppelbrechung führt zu einer unerwünschten Änderung des Arbeitspunktes und der Meßempfindlichkeit.

Zur Kompensation von Temperatureinflüssen sind bereits verschiedene Temperaturkompensationsverfahren bekannt.

In Proc. Conf. Opt. Fiber Sensors OFS 1988, New Orleans, Seiten 288 bis 291 und der zugehörigen US 4 755 665 wird ein Temperaturkompensationsverfahren für eine magnetooptische Meßvorrichtung zum Messen von Wechselströmen vorgeschlagen. Bei diesem Verfahren werden die analog zu der zuvor beschriebenen, aus EP-B-0 088 419 bekannten Meßvorrichtung gewonnenen elektrischen Signale PA und PB jeweils in einem Filter in ihre Gleichstromanteile PA(DC) bzw. PB(DC) und ihre Wechselstromanteile PA(AC) bzw. PB(AC) zerlegt. Aus dem Wechselstromanteil PA(AC) bzw. PB(AC) und dem Gleichstromanteil PA(DC) bzw. PB(DC) wird für jedes Signal PA und PB zum Ausgleich auch von unterschiedlichen Intensitätsschwankungen in den beiden Übertragungsstrecken für die Lichtsignale A und B der Quotient QA = PA(AC)/PA(DC) bzw. QB = PB(AC)/PB(DC) aus seinem Wechselstromanteil PA(AC) bzw. PB(AC) und seinem Gleichstromanteil PA(DC) bzw. PA(DC) gebildet. Aus jedem dieser beiden Quotienten QA und QB wird ein zeitlicher Mittelwert MW(QA) und MW(QB) gebildet, und aus diesen beiden Mittelwerten MW(QA) und MW(QB) wird schließlich ein Quotient Q = MW(QA)/MW(QB) gebildet. Im Rahmen eines Iterationsverfahrens wird durch Vergleich mit in einer Wertetabelle (Look-up-table) gespeicherten, geeichten Werten ein Korrekturfaktor K für den ermittelten Quotienten Q erhalten. Der um diesen Korrekturfaktor K korrigierte Wert Q*K wird als temperaturkompensierter Meßwert für einen zu messenden elektrischen Wechselstrom herangezogen. Mit diesem Verfahren kann die Temperaturempfindlichkeit auf etwa 1/50 herabgesetzt werden.

Aus EP-A-0 557 090 ist ein weiteres Temperaturkompensationsverfahren für eine optische Meßvorrichtung zum Messen magnetischer Wechselfelder bekannt, die den Faraday-Effekt ausnutzt und daher auch zum Messen elektrischer Wechselströme geeignet ist. Bei diesem bekannten Verfahren wird das linear polarisierte Meßlicht nach Durchlaufen des Faraday-Elements in einem Analysator in zwei unterschiedlich linear polarisierte Lichtteilsignale A und B aufgespalten, und es wird zur Intensitätsnormierung für jedes der beiden zugehörigen elektrischen Signale PA und PB gesondert der Quotient QA = PA(AC)/PA(DC) bzw. QB = PB(AC)/PB(DC) aus seinem zugehörigen Wechselstromanteil PA(AC) bzw. PB(AC) und seinem zugehörigen Gleichstromanteil PA(DC) bzw. PB(DC) gebildet. Aus den beiden Quotienten QA und QB wird nun in einer Recheneinheit ein Meßsignal M = 1/((α/QA)-(β/QB)) gebildet mit den reellen Konstanten α und β, die die Beziehung α+β=1 erfüllen. Dieses Meßsignal M wird als weitgehend unabhängig von durch Temperaturänderungen verursachten Änderungen der Verdet-Konstanten und der zirkularen Doppelbrechung im Faraday-Element beschrieben. Über eine Kompensation der temperaturinduzierten linearen Doppelbrechung ist nichts ausgesagt.

Eine weitere Ausführungsform einer optischen Meßvorrichtung zum Messen einer elektrischen Wechselspannung mit Temperaturkompensation betrifft eine optische Reihenschaltung aus einem Polarisator, einem λ/4-Plättchen, einem Pockels-Element und einem polarisierten Strahlteiler als Analysator optisch zwischen eine Lichtquelle und eine Auswerteeinheit geschaltet. Die Reihenfolge von λ/4-Plättchen und Pockels-Element in der optischen Reihenschaltung kann allerdings auch vertauscht sein. Das Meßlicht der Lichtquelle wird in dem Polarisator linear polarisiert und nach Durchlaufen des Pockels-Elements in dem Analysator in zwei Lichtteilsignale A und B mit unterschiedlichen Polarisationsebenen aufgespalten. Jedes dieser Lichtteilsignale A und B wird in ein entsprechendes elektrisches Intensitätssignal PA bzw. PB umgewandelt. Sodann wird zur Intensitätsnormierung für jedes dieser beiden elektrischen Intensitätssignale PA und PB der Quotient QA = PA(AC)/PA(DC) bzw. QB = PB(AC)/PB(DC) aus seinem zugehörigen Wechselsignalanteil PA(AC) bzw. PB(AC) und seinem zugehörigen Gleichsignalanteil PA(DC) bzw. PB(DC) gebildet. Aus den beiden intensitätsnormierten Quotienten QA und QB wird nun in einer Recheneinheit ein Meßsignal $M = 1/((\alpha/QA)-(\beta/QB))$ gebildet mit den reellen Konstanten $\alpha$ und $\beta$. Durch Anpassung dieser Konstanten $\alpha$ und $\beta$ wird das Meßsignal M weitgehend unabhängig von durch Temperaturänderungen verursachter linearer Doppelbrechung im $\lambda/4$-Plättchen.

Die Kompensation von Intensitätsschwankungen durch Trennung der beiden Signale PA und PB in ihre Gleich- und Wechselanteile gemäß den beschriebenen bekannten Verfahren zur Temperaturkompensation hat den Nachteil einer begrenzten Frequenzbandbreite der zu messenden elektrischen Wechselgröße. Um nämlich bei der Filterung der beiden Signale PA und PB keine Informationen über die Wechselgröße zu verlieren, muß die Trennfrequenz zwischen Gleich- und Wechselanteilen unter der Grundfrequenz der Wechselgröße liegen, die üblicherweise bei 50 Hz und in den USA bei 60 Hz liegt. Beispielsweise durch Vibrationen verursachte Intensitätsschwankungen können jedoch durchaus in einem diesen Frequenzen nahekommenden Frequenzbereich liegen und somit mit den bekannten Verfahren nicht eliminiert werden. Will man überdies Wechselströme oder Wechselspannungen mit noch kleineren Frequenzen als 50 Hz messen, so werden die störenden Vibrationseinflüsse mit abnehmender Frequenz noch größer. Dies bereitet insbesondere beim Erfassen von verlagerten Wechselsignalen (offset transient), d.h. Wechselsignalen mit Gleichsignalanteilen, Probleme.

Der Erfindung liegt nun die Aufgabe zugrunde, ein Verfahren und eine Vorrichtung zum Messen einer elektrischen Wechselgröße anzugeben, bei denen Einflüsse von Temperaturänderungen und von Intensitätsschwankungen auf das Meßsignal weitgehend kompensiert werden.

Diese Aufgabe wird gemäß der Erfindung gelöst mit den Merkmalen des Anspruchs 1 bzw. des Anspruchs 13. In ein unter dem Einfluß der elektrischen Wechselgröße stehendes optisches Sensorelement wird polarisiertes Meßlicht eingekoppelt. Beim Durchlaufen des Sensorelements wird die Polarisation des Meßlichts in Abhängigkeit von der elektrischen Wechselgröße geändert. Nach wenigstens einmaligem Durchlaufen des Sensorelements wird das Meßlicht in zwei linear polarisierte Lichtteilsignale mit unterschiedlichen Polarisationsebenen aufgeteilt. Anschließend werden diese beiden Lichtteilsignale jeweils in entsprechende elektrische Intensitätssignale umgewandelt. Aus diesen beiden Intensitätssignalen wird ein intensitätsnormiertes Signal P gebildet, das dem Quotienten aus der Differenz und der Summe der beiden Intensitätssignale entspricht und von Intensitätsschwankungen der Lichtquelle oder in den Übertragungsstrecken für das Meßlicht weitgehend befreit ist. Dieses intensitätsnormierte Signal P wird nun in einen Wechselsignalanteil PAC und einen Gleichsignalanteil PDC zerlegt. Da mit der Bildung des intensitätsnormierten Signals P bereits alle Intensitätsschwankungen im wesentlichen kompensiert sind, kann die Trennfrequenz zwischen dem Wechselsignalanteil PAC und dem Gleichsignalanteil PDC auch sehr klein gewählt werden. Die Bandbreite für die Frequenz der zu messenden elektrischen Wechselgröße ist damit prinzipiell nicht nach unten begrenzt. Es können somit auch niederfrequente Intensitätsschwankungen, die beispielsweise durch Vibrationen hervorgerufen werden können, kompensiert werden. Aus dem Wechselsignalanteil PAC und dem Gleichsignalanteil PDC des intensitätsnormierten Signals P wird nun ein Meßsignal S für die elektrische Wechselgröße abgeleitet, das weitgehend temperaturkompensiert ist.

Die Erfindung beruht dabei auf der Erkenntis, daß der Wechselsignalanteil PAC die Informationen über die elektrische Wechselgröße enthält, der Gleichsignalanteil PDC dagegen Informationen über die Temperatur enthält. Diese Informationen über die Wechselgröße und die Temperatur können somit durch eine geeignete Signalauswertung zum Ableiten des temperaturkompensierten Meßsignals S benutzt werden.

Vorteilhafte Ausführungsformen des Meßverfahrens und der Meßvorrichtung gemäß der Erfindung ergeben sich aus den jeweils abhängigen Ansprüchen.

In einer ersten vorteilhaften Ausführungsform wird das Meßsignal S von einer Recheneinheit gemäß der Vorschrift

$$S = (a * PAC + b * \underline{1})/(c * PDC + d * \underline{1})$$

abgeleitet, wobei a, b, c und d reelle Koeffizienten sind mit $a \neq 0$, $c \neq 0$ und $d \neq 0$ und $\underline{1}$ ein Einheitssignal ist, das betragsmäßig gleich dem intensitätsnormierten Signal P ist, wenn eines der beiden elektrischen Intensitätssignale verschwindet. Durch diese Quotientenbildung zweier linearer Funktionen des Wechselsignalanteils PAC bzw. des Gleichsignalanteils PDC erhält man ein Meßsignal S, bei dem Temperatureinflüsse im Vergleich zum intensitätsnormierten Signal P deutlich reduziert sind.

In einer anderen Ausführungsform wird das Meßsignal S aus dem Wechselsignalanteil PAC und dem Gleichsignalanteil PDC des intensitätsnormierten Signals P mit Hilfe einer vorab ermittelten Wertetabelle oder Eichfunktion abgeleitet.

Zur weiteren Erläuterung der Erfindung wird auf die Zeichnung Bezug genommen, in deren

FIG. 1       ein prinzipieller Aufbau einer Vorrichtung zum Messen einer elektrischen Wechselgröße,

FIG. 2      eine Ausführungsform einer Normierungseinheit für eine solche Meßvorrichtung,

FIG. 3      eine Ausführungsform eines Filters für eine solche Meßvorrichtung,

FIG. 4 und 5      jeweils eine Ausführungsform einer Recheneinheit zur Temperaturkompensation für eine solche Meßvorrichtung,

FIG. 6      eine Ausführungsform einer Vorrichtung zum Messen eines elektrischen Wechselstromes mit einem Faraday-Element,

FIG. 7      eine Ausführungsform zum Messen einer elektrischen Wechselspannung mit einem Pockels-Element und

FIG. 8      ein Diagramm des Meßfehlers mit und ohne Temperaturkompensation

schematisch veranschaulicht sind. Einander entsprechende Teile sind mit denselben Bezugszeichen versehen.

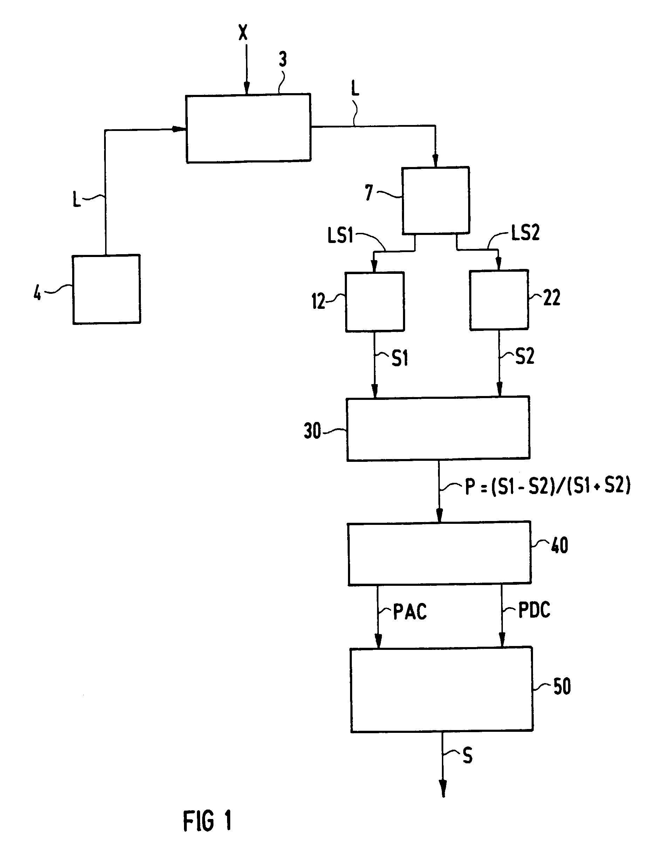

FIG. 1 zeigt eine Ausführungsform der Meßvorrichtung zum Messen einer elektrischen Wechselgröße X in einem prinzipiellen Aufbau. Es ist ein Sensorelement 3 vorgesehen, das unter dem Einfluß der elektrischen Wechselgröße X die Polarisation von in das Sensorelement 3 eingestrahltem polarisierten Meßlicht in Abhängigkeit von der elektrischen Wechselgröße X ändert. Das Sensorelement 3 kann ein Faraday-Element zum Messen eines elektrischen Wechselstromes unter Ausnutzung des magnetooptischen Faraday-Effekts oder auch ein Pockels-Element zum Messen einer elektrischen Wechselspannung oder eines elektrischen Wechselfeldes unter Ausnutzung des elektrooptischen Pockels-Effekts sein. In das Sensorelement 3 wird polarisiertes Meßlicht L eingekoppelt. Zum Erzeugen dieses polarisierten Meßlichts L können eine Lichtquelle 4 und zugeordnete, nicht dargestellte polarisierende Mittel oder auch eine selbst polarisierende Lichtquelle 4, beispielsweise eine Laserdiode, und gegebenenfalls zusätzliche, nicht dargestellte polarisierende Mittel vorgesehen sein. Das polarisierte Meßlicht L durchläuft das Sensorelement 3 wenigstens einmal und erfährt dabei eine von der elektrischen Wechselgröße X abhängige Änderung seiner Polarisation. Nach dem

Durchlaufen des Sensorelements 3 wird das Meßlicht L einem Analysator 7 zugeführt und im Analysator 7 in zwei linear polarisierte Lichtteilsignale LS1 und LS2 zerlegt, deren Polarisationsebenen verschieden voneinander sind. Vorzugsweise sind die Polarisationsebenen der beiden Lichtteilsignale LS1 und LS2 senkrecht zueinander gerichtet (orthogonale Zerlegung). Als Analysator 7 können ein polarisierender Strahlteiler, beispielsweise ein Wollaston-Prisma, oder auch zwei um einen entsprechenden Winkel und vorzugsweise um 90° gekreuzte Polarisationsfilter und ein einfacher Strahlteiler mit einem teildurchlässigen Spiegel vorgesehen sein. Das Sensorelement 3 und der Analysator 7 können über eine Freistrahlanordnung oder auch über einen polarisationserhaltenden Lichtleiter, vorzugsweise eine Monomode-Lichtfaser wie beispielsweise eine HiBi(High Birefringence)-Faser oder eine polarisationsneutrale LoBi(Low Birefringence)-Faser, optisch miteinander verbunden sein.

Die beiden Lichtteilsignale LS1 und LS2 werden dann jeweils einem photoelektrischen Wandler 12 bzw. 22 zugeführt. Die Übertragung der beiden Lichtteilsignale LS1 und LS2 vom Analysator 7 zu dem jeweils zugehörigen Wandler 12 bzw. 22 kann über eine Freistrahlanordnung oder über jeweils einen Lichtleiter erfolgen. In den Wandlern 12 und 22 werden die beiden Lichtteilsignale LS1 und LS2 jeweils in ein elektrisches Intensitätssignal S1 bzw. S2 umgewandelt, das ein Maß für die Intensität des zugehörigen Lichtteilsignals LS1 bzw. LS2 ist. Diese beiden Intensitätssignale S1 bzw. S2 werden Eingängen einer Normierungseinheit 30 zugeführt. Die Normierungseinheit 30 bildet aus den beiden elektrischen Intensitätssignalen S1 und S2 ein intensitätsnormiertes Signal

$$P = (S1 - S2)/(S1 + S2),$$

das dem Quotienten aus der Differenz und der Summe der beiden Intensitätssignale S1 und S2 entspricht. Dieses intensitätsnormierte Signal P ist im wesentlichen unabhängig von Intensitätsschwankungen der Lichtquelle 4 oder Intensitätsverlusten in den Übertragungswegen. Das intensitätsnormierte Signal P wird vorzugsweise mit Hilfe analoger arithmethischer Komponenten gebildet, kann aber auch digital berechnet oder Mit Hilfe einer gespeicherten Wertetabelle ermittelt werden.

Ein Problem bereiten nun jedoch Änderungen der Temperatur aufgrund von temperaturinduzierter linearer Doppelbrechung in den optischen Materialien der optischen Meßvorrichtung, insbesondere des Sensorelements 3, und die damit verbundene Verschiebung des Arbeitspunktes und Änderung der Meßempfindlichkeit der Meßvorrichtung. Diese temperaturinduzierten Meßfehler werden nun durch ein im folgenden beschriebenes Temperaturkompensationsverfahren mit Hilfe eines Filters 40 und einer Recheneinheit 50 weitgehend kompensiert.

Das an einem Ausgang der Normierungseinheit 30 anstehende intensitätsnormierte Signal P wird dazu einem Eingang des Filters 40 zugeführt. Das Filter 40 zerlegt das intensitätsnormierte Signal P in seinen Wechselsignalanteil PAC und seinen Gleichsignalanteil PDC, die jeweils an einem Ausgang des Filters 40 anliegen.

Dieser Wechselsignalanteil PAC und dieser Gleichsignalanteil PDC werden nun jeweils einem Eingang der Recheneinheit 50 zugeführt. Die Recheneinheit 50 bildet aus dem Wechselsignalanteil PAC und dem Gleichsignalanteil PDC ein Meßsignal S gemäß der Vorschrift

$$S = (a * PAC + b * \underline{1})/(c * PDC + d * \underline{1}) \qquad (1),$$

wobei a, b, c und d reelle Koeffizienten sind mit $a \neq 0$, $c \neq 0$ und $d \neq 0$ und $\underline{1}$ ein Einheitssignal ist, das einem Wert P = 1 entspricht. Es hat sich gezeigt, daß mit diesem Meßsignal S sowohl beim Messen eines Wechselstromes als elektrische Wechselgröße X Mit Hilfe eines Faraday-Elements als auch beim Messen eines Wechselfeldes oder einer Wechselspannung als elektrische Wechselgröße X Mit Hilfe eines Pockels-Elements ein sowohl gegenüber Intensitätschwankungen der Lichtquelle und in den optischen Übertragungsstrecken als auch bezüglich seines Arbeitspunktes bei veränderlichen Temperaturen weitgehend stabiles Meßsignal für die entsprechende elektrische Wechselgröße X erhalten wird. Die Koeffizienten a,b,c und d können zur Optimierung der Temperaturunabhängigkeit des Meßsignals S experimentell ermittelt werden. Die arithmethische Herleitung des Meßsignals S gemäß der Gleichung (1) wird vorzugsweise Mit Hilfe von entsprechenden analogen Bauelementen für die auszuführenden arithmetischen Operationen durchgeführt. In dieser Ausführungsform ist eine Temperaturkompensation in Echtzeit möglich. Das Meßsignal S kann aber auch digital mit Hilfe eines Mikroprozessors oder Computers berechnet oder mit Hilfe einer gespeicherten Wertetabelle ermittelt werden. Die Temperaturempfindlichkeit des Meßsignals S ist deutlich geringer als die des unkompensierten Signals P. Der Meßfehler kann dabei um etwa einen Faktor 10 verringert werden.

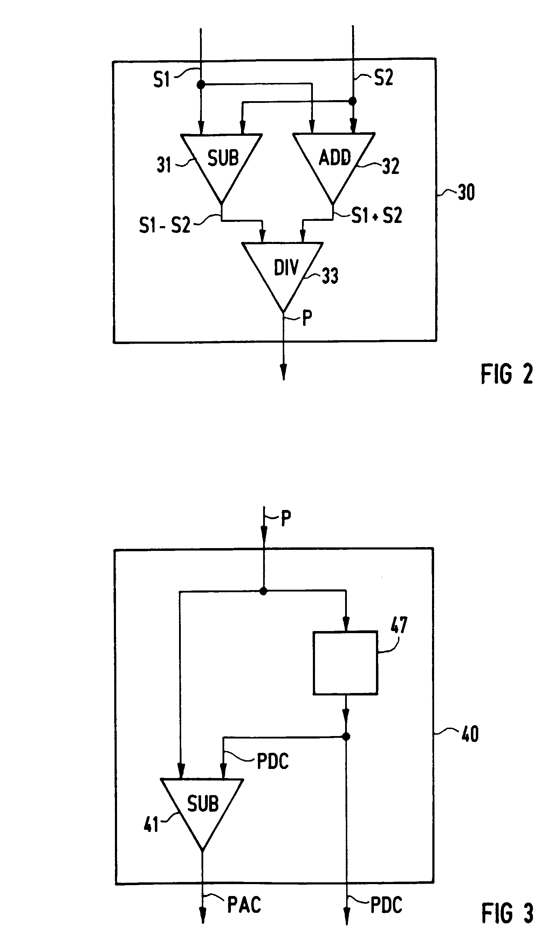

Die FIG. 2 zeigt eine Ausführungsform der Normierungseinheit 30. Es sind ein Subtrahierer 31, ein Addierer 32 und ein Dividierer 33 vorgesehen. An jeweils zwei Eingängen des Subtrahierers 31 und des Addierers 32 werden die beiden elektrischen Intensitätssignale S1 und S2 angelegt. Das an einem Ausgang des Subtrahierers 31 anstehende Differenzsignal S1-S2 und das an einem Ausgang des Addierers 32 anstehende Summensignal S1+S2 werden zwei Eingängen des Dividierers 33 zugeführt. An einem Ausgang des Dividierers 33 steht dann das intensitätsnormierte Signal P = (S1-S2)/(S1+S2) an. Diese Ausführungsform hat den Vorteil, daß die Intensitätsnormierung in Echtzeit erfolgen kann, wenn analoge Bauelemente verwendet werden.

In der FIG. 3 ist eine Ausführungsform des Filters 40 zum Zerlegen des intensitätsnormierten Signals P in seinen Wechselsignalanteil PAC und sein Gleichsignalanteil PDC dargestellt. Das Filter 40 enthält ein Tiefpaßfilter 47 und einen Subtrahierer 41. Das intensitätsnormierte Signal P wird an einen Eingang des Tiefpaßfilters 47 angelegt. An einem Ausgang des Tiefpaßfilters 47 steht dann der Gleichsignalanteil PDC des intensitätsnormierten Signals P an, der den Frequenzanteilen des intensitätsnormierten Signals P entspricht, die unterhalb einer vorgegebenen Trennfrequenz des Tiefpaßfilters 47 liegen. Diese Trennfrequenz des Tiefpaßfilters 47 kann auch niedrig eingestellt werden, weil Intensitätsschwankungen bereits bei der vorangegangenen Intensitätsnormierung in der Normierungseinheit 30 eliminiert sind und somit störende höherfrequente Intensitätsschwankungen, beispielsweise infolge von Vibrationen, sich nicht mehr störend auf den Wechselsignalanteil PAC auswirken können. Der Wechselsignalanteil PAC wird nun einfach durch Subtraktion des Gleichsignalanteils PDC vom Gesamtsignal P mit Hilfe des Subtrahierers 41 gebildet. Dazu werden an zwei Eingängen des Subtrahierers 41 das intensitätsnormierte Signal P und der Gleichsignalanteil PDC des intensitätsnormierten Signals P angelegt.

Anstelle der in FIG. 3 gezeigten Ausführungsformen des Filters 40 können natürlich auch ein Hochpaßfilter und ein Tiefpaßfilter zum Herausfiltern des Wechselsignalanteils PAC bzw. des Gleichsignalanteils PDC vorgesehen sein oder auch ein Hochpaßfilter zum Herausfiltern des Wechselsignalanteils PAC und ein Subtrahierer zum Ableiten des Gleichsignalanteils PDC durch Subtraktion des Wechselsignalanteils PAC vom Gesamtsignal P.

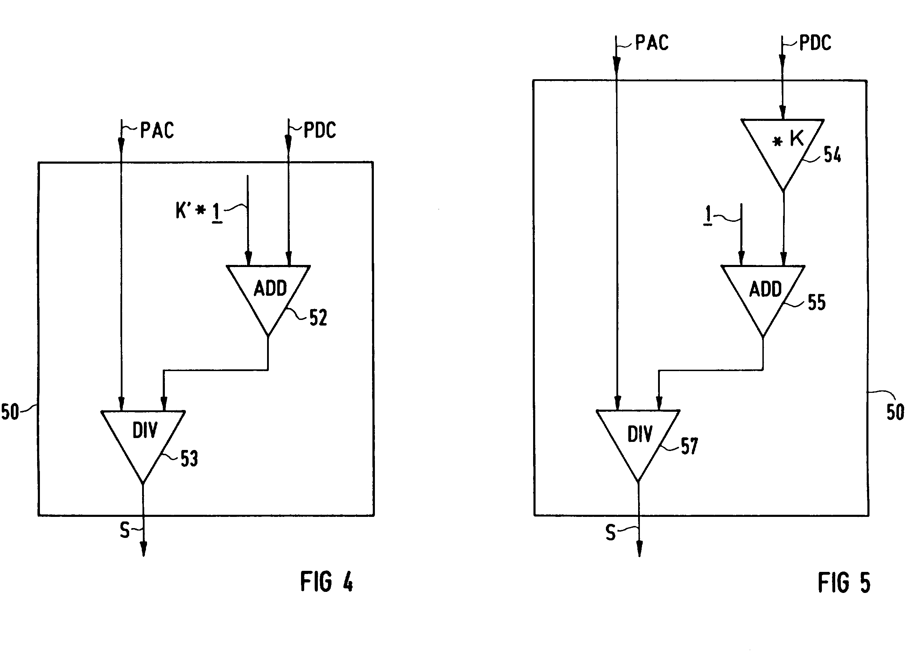

Die FIG. 4 und 5 zeigen zwei besonders einfache Ausführungsformen der Recheneinheit 50 und der in dieser Recheneinheit 50 durchgeführten Berechnung des Meßsignals S.

In der Ausführungsform gemäß FIG. 4 enthält die Recheneinheit 50 einen Addierer 52 und einen Dividierer 53. Der Addierer 52 bildet ein Summensignal PDC + K'*$\underline{1}$ aus dem Gleichsignalanteil PDC des intensitätsnormierten Signals P und einem mit einem vorgegebenen reellen Korrekturfaktor K' multiplizierten Einheitssignal 1. Dazu werden dem Addierer 52 der Gleichsignalanteil PDC und das mit dem Korrekturfaktor K' multiplizierte Einheitssignal $\underline{1}$ als Eingangssignale zugeführt. Das Einheitssignal $\underline{1}$ entspricht dabei betragsmäßig dem intensitätsnormierten Signal P = $\pm\underline{1}$, das sich ergibt, wenn genau eines der beiden Intensitätssignale S1 oder S2 verschwindet. Das ist beispielsweise der Fall, wenn S2 = 0 ist und S1 $\neq$ 0. Am Ausgang des Addierers 52 steht somit das Summensignal PDC + K'*$\underline{1}$ aus dem Gleichsignalanteil PDC und dem mit dem Korrekturfaktor K' multiplizierten Einheitssignal $\underline{1}$ an. Vom Dividierer 53 wird der Quotient PAC/(PDC + K'*$\underline{1}$) aus dem Wechselsignalanteil PAC und dem Summensignal PDC + K'*$\underline{1}$ gebildet. Dazu wird an einen ersten Eingang des Dividierers 53 der Wechselsignalanteil PAC und an einen zweiten Eingang des Dividierers 53 das Summensignal PDC + K'*$\underline{1}$ des Addierers 42 angelegt. Der an dem Ausgang des Dividierers 53 anstehende Quotient wird als Meßsignal

$$S = PAC/(PDC + K'*\underline{1}) \qquad (2)$$

für die elektrische Wechselgröße X herangezogen. Durch eine geeignete experimentell ermittelbare Wahl des Korrekturfaktors K' kann die Temperaturabhängigkeit des Meßsignals S minimiert werden.

In der in FIG. 5 gezeigten Ausführungsform der Recheneinheit 50 sind anstelle des Addierers 52 ein Verstärker 54 und ein Addierer 55 vorgesehen, die gemeinsam Mittel zum Erzeugen eines Summensignals K*PDC + $\underline{1}$ aus dem mit einem vorgegebenen reellen Korrekturfaktor K multiplizierten Gleichsignalanteil PDC und dem Einheitssignal $\underline{1}$ bilden. Dazu wird der Gleich signalanteil PDC dem Verstärker 54 als Eingangssignal zugeführt und in dem Verstärker 54 mit dem auf den Korrekturfaktor K eingestellten Verstärkungsfaktor des Verstärkers 54 multipliziert. Das Ausgangssignal K*PDC des Verstärkers 54 wird als erstes Eingangssignal einem Eingang des Addierers 55 zugeführt. Ein zweites Eingangssignal an einem weiteren Eingang des Addierers 55 bildet das Einheitssignal $\underline{1}$. Somit steht am Ausgang des Addierers 55 das Summensignal K*PDC + $\underline{1}$ an. An einen ersten Eingang des Dividierers 53 wird wieder wie in FIG. 4 der Wechselsignalanteil PAC angelegt, während der zweite Eingang des Dividierers 53 nun mit dem Ausgang des Addierers 55 verbunden ist. Am Ausgang des Dividierers 53 steht somit der Quotient PAC/(K*PDC + $\underline{1}$) aus dem Wechselsignalanteil PAC und dem Summensignal K*PDC + $\underline{1}$ an. Dieser Quotient wird nun als Meßsignal

$$S = PAC/(K*PDC + \underline{1}) \qquad (3)$$

für die elektrische Wechselgröße X herangezogen. Dieses Meßsignal S ist ebenso wie das Meßsignal S gemäß FIG. 4 und Gleichung (2) sowohl hinsichtlich Temperaturänderungen als auch hinsichtlich Intensitätsänderungen weitgehend stabil.

Der Korrekturfaktor K wird vorzugsweise so eingestellt, daß die Temperaturabhängigkeit des Meßsignals S wenigstens annähernd minimal ist.

Die Berechnung des Meßsignals S kann in allen Ausführungsformen in Echtzeit erfolgen, weil die Recheneinheit 50 mit analogen Bauelementen realisiert werden kann.

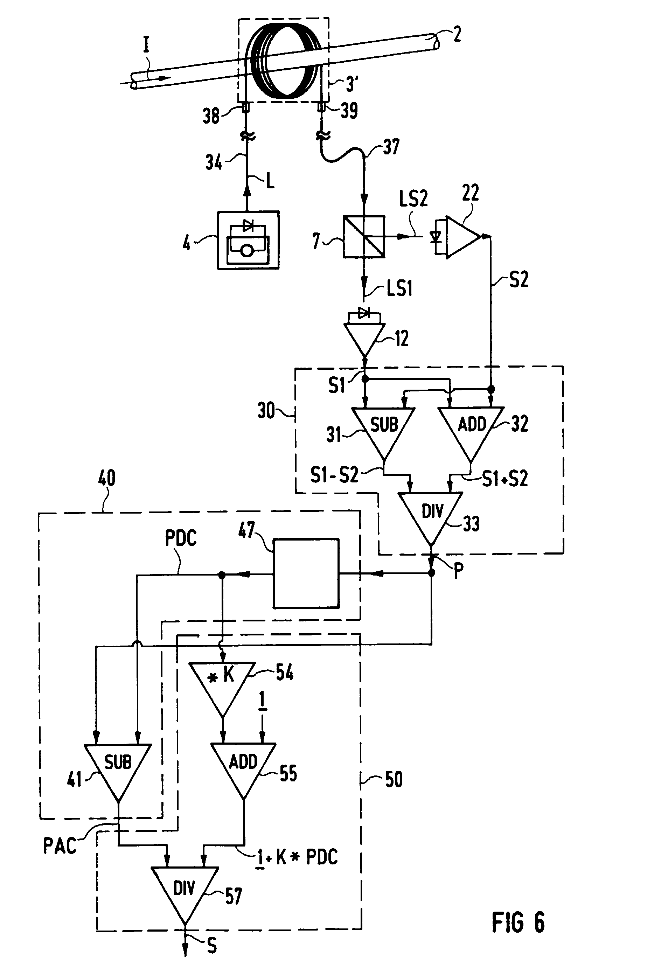

In der FIG. 6 ist eine Ausführungsform einer Meßvorrichtung zum Messen eines elektrischen Wechselstromes I in einem Stromleiter 2 mit einem dem Stromleiter 2 zugeordneten Faraday-Element 3' als Sensorelement dargestellt.

Linear polarisiertes Meßlicht L einer linear polarisierten Lichtquelle 4 wird über einen vorzugweise polarisationserhaltenden Lichtleiter 34 in das Faraday-Element 3' eingekoppelt, nach wenigstens einem Durchlauf durch das Faraday-Element 3' aus dem Faraday-Element 3' wieder ausgekoppelt und über einen vorzugsweise polarisationserhaltenden Lichtleiter 37 dem Analysator 7 zugeführt. Die Übertragung des ausgekoppelten Meßlichts vom Faraday-Element 3' zum Analysator 7 kann aber auch über eine Freistrahlanordnung erfolgen. Das ausgekoppelte Meßlicht weist eine aufgrund des Faraday-Effekts um einen nicht dargestellten Meßwinkel $\alpha$ gedrehte Polarisation auf. Der Meßwinkel $\alpha$ ist dabei abhängig von einem Wechselstrom I in dem Stromleiter 2.

In der dargestellten Ausführungsform gemäß FIG. 6 ist das Faraday-Element 3' mit einem Lichtleiter, vorzugsweise einer optischen Faser, gebildet, der den Stromleiter 2 in einer Meßwicklung mit wenigstens einer Meßwindung umgibt. Der Lichtleiter des Faraday-Elements 3' ist mit dem Lichtleiter 34 zum Zuführen des Meßlichts L und mit dem Lichtleiter 37 zum Abführen des Meßlichts L vorzugsweise jeweils über einen Spleiß 35 bzw. 39 verbunden.

Als Faraday-Element 3' können jedoch auch ein oder mehrere massive Körper aus einem Faraday-Material, der bzw. die einen vorzugsweise den Stromleiter 2 umgebenden Lichtpfad für das Meßlicht bilden, vorgesehen sein, vorzugsweise ein Glasring. Das Faraday-Element 3' muß den Stromleiter 2 nicht in einem geschlossenen Lichtpfad umgeben, sondern kann auch nur in räumliche Nähe neben dem Stromleiter 2 angeordnet sein. Außerdem ist neben der dargestellten Ausführungsform vom Transmissionstyp, bei der das Meßlicht das Faraday-Element 3' nur in einer Richtung durchläuft, auch eine Ausführungsform vom Reflexionstyp möglich, bei der das Meßlicht L nach einem ersten Durchlauf in das Faraday-Element 3' zurückreflektiert wird und das Faraday-Element 3' ein zweites Mal in umgekehrter Richtung durchläuft.

Das aus dem Faraday-Element 3' ausgekoppelte Licht wird von dem Analysator 7 in zwei linear polarisierte Lichtsignale LS1 und LS2 mit verschiedenen und vorzugsweise senkrecht zueinander gerichteten Polarisationsebenen aufgespalten. Dazu ist als Analysator 7 vorzugsweise ein polarisierender Strahlteiler wie beispielsweise ein Wollaston-Prisma vorgesehen. Es können für diese Funktion allerdings auch zwei um einen entsprechenden Winkel und vorzugsweise um 90° gekreuzte Polfilter und ein einfacher Strahlteiler vorgesehen sein.

Die beiden Lichtsignale LS1 und LS2 werden dann in zugeordneten optoelektrischen Wandlern 12 bzw. 22, für die vorzugsweise in Verstärkerkreise geschaltete Photodioden vorgesehen sind, in elektrische Intensitätssignale S1 bzw. S2 umgewandelt, die ein Maß für die Lichtintensitäten der jeweiligen Lichtsignale LS1 bzw. LS2 sind.

Die elektrischen Intensitätssignale S1 und S2 werden nun der Normierungseinheit 30 zugeführt, die vorzugsweise wie in FIG. 2 dargestellt aufgebaut ist. An einem Ausgang der Normierungseinheit 30 steht das intensitätsnormierte Signal P = (S1-S2)/(S1+S2) an. Dieses intensitätsnormierte Signal P ist intensitätsschwankungskompensiert, d.h. Schwankungen in den Lichtintensitäten insbesondere durch Mikrobiegeverluste in den Lichtleitern infolge von Vibrationen oder sonstigen mechanischen Einwirkungen und durch Schwankungen der Intensität der Lichtquelle 4 sind praktisch eliminiert.

Um nun auch eine Temperaturkompensation vorzunehmen, wird das intensitätsnormierte Signal P von dem Filter 40 in seinen Wechselsignalanteil PAC und seinen Gleichsignalanteil PDC zerlegt. Dazu sind wieder wie in der Ausführungsform gemäß FIG. 3 das Tiefpaßfilter 47 und der Subtrahierer 41 vorgesehen. Es können natürlich auch andere Ausführungsformen des Filters 40 verwendet werden.

Der Wechselsignalanteil PAC und der Gleichsignalanteil PDC werden nun der Recheneinheit 50 zugeführt. Die dargestellte Recheneinheit 50 entspricht der vorteilhaften Ausführungsform gemäß FIG. 5 und der Gleichung (3), ist aber nicht auf diese Ausführungsform beschränkt und kann beispielsweise auch gemäß FIG. 4 und Gleichung (2) oder zum Herleiten eines Meßsignals S gemäß Gleichung (1) ausgebildet sein. Als Meßsignal S für den elektrischen Wechselstrom I wird in der dargestellten Ausführungsform somit der Quotient PAC/(K*PDC + 1) herangezogen.

Die Abhängigkeit des Meßsignals S von der Temperatur kann durch geeignete Wahl des Korrekturfaktors K minimiert werden. In einer besonders vorteilhaften Ausführungsform werden dazu der nicht dargestellte Einkoppelwinkel $\eta$ der Polarisationsebene des in das Faraday-Element 3' eingekoppelten linear polarisierten Meßlichts L zu einer Eigenachse der linearen Doppelbrechung des Faraday-Elements 3' und der ebenfalls nicht dargestellte Auskoppelwinkel $\theta$ zwischen dieser Eigenachse und einer Eigenachse des Analysators 7 sowie der Korrekturfaktor K so eingestellt, daß wenigstens annähernd die Bedingungen erfüllt sind:

$$\cos (2 \cdot \theta + 2 \cdot \eta) = -2/(3 \cdot K) \qquad (4a)$$

$$\sin(2 \cdot \theta - 2 \cdot \eta) = 1 \qquad (4b).$$

Eine Eigenachse eines doppelbrechenden Materials ist dabei durch den Polarisationszustand definiert, der das Material unverändert wieder verläßt. Mögliche Winkelwerte als Lösungen der genannten Gleichungen (4a) und (4b) sind beispielsweise $\eta$ = 10,45° und $\theta$ = 55,45° für K=2. Abweichungen von den die genannten Bedingungen (4a) und (4b) exakt erfüllenden Winkelwerten sind insbesondere bei großer linearer und/oder zirkularer Doppelbrechung im Faraday-Element 3' möglich und können bis zu etwa 5° betragen.

Rechnungen ergaben, daß bei derart in Abhängigkeit vom Korrekturfaktor K gewählten Einkoppelwinkel $\eta$ und Auskoppelwinkel $\theta$ das Meßsignal S eine besonders einfache Abhängigkeit von dem Faraday-Drehwinkel oder Meßwinkel $\alpha$ aufweist. Es gilt nämlich dann in guter Näherung die Beziehung

$$S = \sin(2 \cdot \alpha) \qquad (5).$$

Dieses Meßsignal S entspricht dem theoretischen Meßsignal für den Meßwinkel $\alpha$ ohne Doppelbrechungseffekte. Dadurch wird das Auswerteverfahren besonders einfach. Bei vorgegebenen Einkoppel- und Auskoppelwinkeln $\eta$ bzw. $\theta$ ist der Korrekturfaktor K gerade so einzustellen, daß das Meßsignal S der Meßvorrichtung dem Meßsignal bei nicht vorhandener Doppelbrechung entspricht. Mit diesem Korrekturfaktor K ist die Meßvorrichtung dann auf minimale Temperaturdrift justiert.

Legt man der Berechnung des Meßsignals S dagegen die beispielsweise mit einer Recheneinheit 50 gemäß FIG. 4 durchführbare Vorschrift S = PAC/(PDC + K'*1) gemäß Gleichung (2) zugrunde, so lauten die Beziehungen zwischen dem Korrekturfaktor K' und dem Einkoppelwinkel $\eta$ sowie dem Auskoppelwinkel $\theta$ wie folgt:

$$\cos(2 \cdot \theta + 2 \cdot \eta) = -(2/3) \cdot K' \qquad (6a)$$

$$\sin(2 \cdot \theta - 2 \cdot \eta) = 1 \qquad (6b).$$

Mit gemäß diesen Gleichungen (6a) und (6b) eingestellten Winkeln $\eta$ und $\theta$ in Abhängigkeit vom Korrekturfaktor K' erhält man als Meßsignal

$$S = (1/K') \cdot \sin (2 \cdot \alpha) \qquad (7),$$

das dem theoretischen Meßsignal $\sin(2 \cdot \alpha)$ ohne Doppelbrechung bis auf eine Skalierung mit dem Faktor 1/K' entspricht.

Mögliche Winkelwerte als Lösungen der genannten Gleichungen (6a) und (6b) sind beispielsweise $\eta$ = 10,45° und $\theta$ = 55,45° für K' = 1. Abweichungen von den die Bedingungen (6a) und (6b) exakt erfüllenden Winkelwerten sind insbesondere bei großer linearer und/oder zirkularer Doppelbrechung im Faraday-Element 3' möglich und können bis zu etwa 5° betragen.

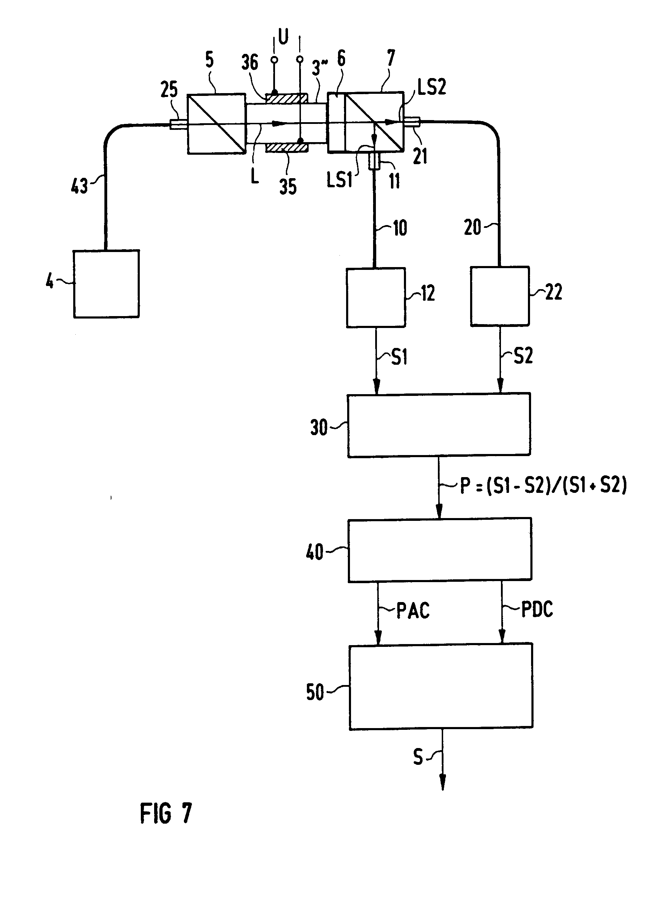

FIG. 7 zeigt eine Ausführungsform einer Vorrichtung zum Messen einer elektrischen Wechselspannung U als Wechselgröße X mit einem Pockels-Element 3". Die zu messende Wechselspannung U ist über zwei Elektroden 35 und 36 an das Pockels-Element 3" anlegbar. In das Pockels-Element 3" wird polarisiertes Meßlicht L eingekoppelt. Dieses Meßlicht L durchläuft das Pockels-Element 3" und erfährt dabei eine von der angelegten Wechselspannung U abhängige Änderung seiner Polarisation. Die Wechselspannung U wird in der dargestellten Ausführungsform senkrecht zur Lichtausbreitungsrichtung des Meßlichts L angelegt (transversale Ausführungsform), kann aber auch parallel zur Lichtausbreitungsrichtung angelegt werden (longitudinale Ausführungsform). Als Mittel zum Einkoppeln des Meßlichtes L in das Pockels-Element 3" sind eine Lichtquelle 4, beispielsweise eine Leuchtdiode, und ein Polarisator 5 zum linearen Polarisieren des Lichts der Lichtquelle 4 vorgesehen. Die Lichtquelle 4 und der Polarisator 5 sind vorzugsweise über einen Lichtleiter 43, beispielsweise eine Multimode-Lichtfaser, optisch miteinander verbunden, können aber auch durch eine Freistrahlkopplung optisch miteinander gekoppelt sein. Zum Einkoppeln des Lichts aus dem Lichtleiter 43 in den Polarisator 5 ist vorzugsweise eine Kollimatorlinse (Grin lens) 25 vorgesehen. Aus dem Polarisator 5 wird das nun linear polarisierte Meßlicht L in das Pockels-Element 3" eingekoppelt. Nach Durchlaufen des Pockels-Elements 3 wird das Meßlicht L über ein $\lambda$/4-Plättchen 6 dem Analysator 7 zugeführt. In dem Analysator 7 wird das Meßlicht L in zwei linear polarisierte Lichtteilsignale LS1 und LS2 zerlegt, deren Polarisationsebenen verschieden voneinander sind. Vorzugsweise sind die Polarisationsebenen der beiden Lichtteilsignale LS1 und LS2 senkrecht zueinander gerichtet (orthogonale Zerlegung). Als Analysator 7 können ein polarisierender Strahlteiler, beispielsweise ein Wollaston-Prisma, oder auch zwei um einen vorgegebenen Winkel, vorzugsweise 90°, gekreuzte Polarisationsfilter und ein einfacher Strahlteiler vorgesehen sein.

Die beiden Lichtteilsignale LS1 und LS2 werden vorzugsweise über jeweils eine Kollimatorlinse 11 bzw. 21 in jeweils einen Lichtleiter 10 bzw. 20 eingekoppelt und über diesen Lichtleiter 10 bzw. 20 jeweils dem zugehörigen photoelektrischen Wandler 12 bzw. 22 zugeführt. In den Wandlern 12 und 22 werden die beiden Lichtteilsignale LS1 und LS2 jeweils in ein elektrisches Intensitätssignal S1 bzw. S2 umgewandelt, das ein Maß für die Intensität des zugehörigen Lichtteilsignals LS1 bzw. LS2 ist. Diese beiden Intensitätssignale S1 bzw. S2 werden Eingängen einer Normierungseinheit 30 zugeführt. Die Normierungseinheit 30 bildet aus den beiden elektrischen Intensitätssignalen S1 und S2 ein intensitätsnormiertes Signal P = (S1 - S2)/(S1 + S2), das dem Quotienten aus der Differenz und der Summe der beiden Intensitätssignale S1 und S2 entspricht. Dieses intensitätsnormierte Signal P ist im wesentlichen unabhängig von Intensitätsschwankungen der Lichtquelle 4 oder Intensitätsverlusten in den Übertragungswegen.

Der Arbeitspunkt der Meßvorrichtung wird vorzugsweise so eingestellt, daß am Analysator 7 zirkular polarisiertes Meßlicht anliegt, wenn am Pockels-Element 3" kein elektrisches Feld anliegt. Die beiden Eigenachsen der linearen Doppelbrechung im Pockels-Element 3" sind in diesem Fall vom Meßlicht L "gleichmäßig ausgeleuchtet". Das bedeutet, daß die auf die beiden Eigenachsen projizierten Komponenten des Meßlichts L jeweils die gleiche Intensität aufweisen. Im allgemeinen sind dann die beiden Lichtteilsignale LS1 und LS2 ebenfalls gleich stark in ihrer Intensität und das intensitätsnormierte Signal P ist gleich Null für U = 0 V. Bei Anlegen einer Wechselspannung U ≠ 0 V an das Pockels-Element 3" werden die Komponenten des Meßlichts L entlang der elektrooptisch aktiven Eigenachsen der linearen Doppelbrechung des Pockels-Elements 3" in ihrer Intensität in Abhängigkeit von der Wechselspannung U geändert.

Eine solche Änderung der Polarisation des Meßlichts L wird jedoch auch verursacht durch eine Änderung der Temperatur im Pockels-Element 3" oder auch dem $\lambda$/4-Plättchen 6 und einer damit bewirkten temperaturabhängigen linearen Doppelbrechung. Temperaturänderungen führen somit zu einer Verschiebung des Arbeitspunktes der Meßvorrichtung. Diese temperaturabhängige Arbeitspunktdrift wird nun durch das bereits beschriebene Temperaturkompensationsverfahren mit Hilfe des Filters 40 und der Recheneinheit 50 weitgehend kompensiert.

Das an einem Ausgang der Normierungseinheit 30 anstehende intensitätsnormierte Signal P wird dazu einem Eingang des Filters 40 zugeführt. Das Filter 40 zerlegt das intensitätsnormierte Signal P in seinen Wechselsignalanteil PAC und seinen Gleichsignalanteil PDC, die jeweils an einem Ausgang des Filters 40 anliegen. Dieser Wechselsignalanteil PAC und dieser Gleichsignalanteil PDC werden nun jeweils einem Eingang der Recheneinheit 50 zugeführt. Die Recheneinheit 50 bildet aus dem Wechselsignalanteil PAC und dem Gleichsignalanteil PDC ein Meßsignal S gemäß der Vorschrift

$$S = (a * PAC + b * \underline{1})/(c * PDC + d * \underline{1}),$$

wobei a, b, c und d reelle Koeffizienten sind mit a ≠ 0, c ≠ 0 und d ≠ 0 und $\underline{1}$ ein Einheitssignal ist.

Durch die Intensitätssnormierung in der Normierungseinheit 30 und die anschließende Temperaturkompensation mit Hilfe des Filters 40 und der Recheneinheit 50 wird somit ein Meßsignal S für die elektrische Wechselspannung U erhalten, das sowohl von Intensitätsschwankungen als auch von Temperatureinflüssen weitgehend befreit ist.

Anstelle der in FIG. 7 dargestellten optischen Reihenschaltung des Polarisators 5, des Pockels-Elements 3", des $\lambda$/4-Plättchens 6 und des Analysators 7 kann auch eine optische Reihenschaltung aus dem Polarisator 5, dem $\lambda$/4-Plättchen 6, dem Pockels-Element 3" und dem Analysator 7 vorgesehen sein, also die Reihenfolge des $\lambda$/4-Plättchens 6 und des Pockels-Elements 3" gerade vertauscht sein. In diesem Fall wird das Meßlicht L vor dem Einkoppeln in das Pockels-Element 3" zirkular polarisiert.

Außerdem kann anstelle der Lichtquelle 4 und des Polarisators 5 auch eine Lichtquelle zum Senden linear polarisierten Lichts wie beispielsweise eine Laserdiode vorgesehen sein zum Einkoppeln von polarisiertem Meßlicht L in das Pockels-Element 3" bzw. das $\lambda$/4-Plätt-

chen 6. Der Lichtleiter 43 ist dann vorzugsweise ein polarisationserhaltender Lichtleiter.

Die Übertragung der Lichtteilsignale LS1 bzw. LS2 kann ferner auch in einer Freistrahlanordnung erfolgen. Der Analysator 7 kann überdies mit dem $\lambda$/4-Plättchen 6 bzw. dem Pockels-Element 3" über einen polarisationserhaltenden Lichtleiter optisch verbunden sein.

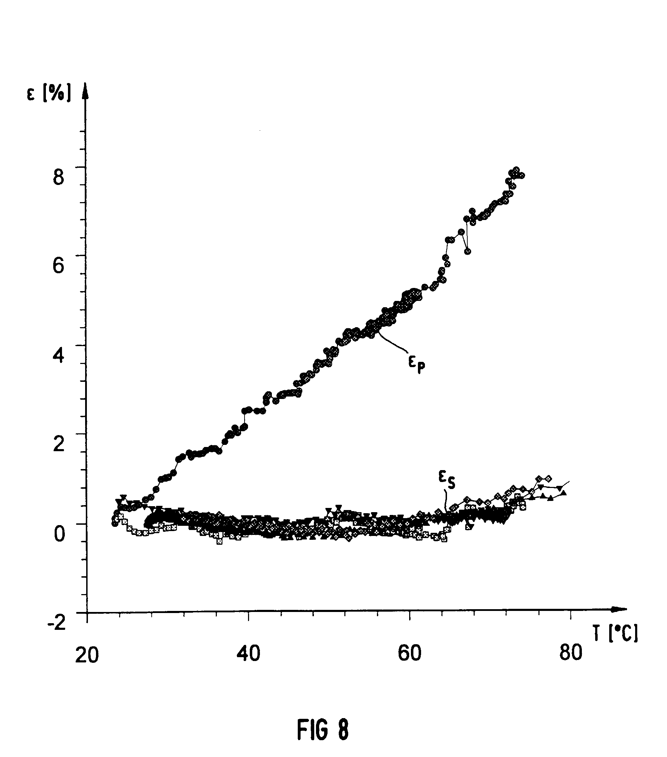

Die FIG. 8 zeigt in einem Diagramm gemessene Kurven zur Temperaturabhängigkeit des Meßsignals S und des unkompensierten Signals P. Es ist der Meßfehler $\varepsilon = \varepsilon(T)$ als Funktion der Temperatur T aufgetragen. Die einzelnen Punkte entsprechen gemessenen Werten. Die mit $\varepsilon_P$ bezeichnete Kurve entspricht dem Meßfehler in Abhängigkeit von der Temperatur beim noch nicht temperaturkompensierten Signal P. Man erkennt die näherungsweise lineare Zunahme des Meßfehlers mit steigender Temperatur. Die mit $e_S$ bezeichnete Meßkurve entspricht dem Meßfehler in Abhängigkeit von der Temperatur beim temperaturkompensierten Meßsignal S. Der Meßfehler ist demnach im wesentlichen konstant über der Temperatur. Die gezeigten Meßwerte wurden mit einer Vorrichtung gemäß FIG. 6 zum Messen eines elektrischen Wechselstromes gemessen.

Das Meßsignal S kann außer mit Hilfe einer der Formeln (1), (2) oder (3) in einer nicht dargestellten Ausführungsform auch mit Hilfe einer vorab ermittelten und in wenigstens einem Speicher abgelegten Wertetabelle oder einer vorab ermittelten, gespeicherten Eichfunktion aus dem Wechselsignalanteil,PAC und dem Gleichsignalanteil PDC des intensitätsnormierten Signals P abgeleitet werden. Jedem Wertepaar für den Wechselsignalanteil PAC und den Gleichsignalanteil PDC wird mit Hilfe der Wertetabelle oder der Eichfunktion das Meßsignal S als Funktion F(PAC,PDC) des Wechselsignalanteils PAC und des Gleichsignalanteils PDC zugeordnet. Für zwischen den gespeicherten Werten liegende aktuelle Signale PAC und PDC wird dabei in gängiger Art und Weise interpoliert. Die zugehörige Funktion F(PAC,PDC) kann experimentell ermittelt werden oder theoretisch angenähert werden.

In einer besonderen Ausführungsform wird als Funktion F(PAC,PDC) für das Meßsignal S das Produkt PAC*f(PDC) aus dem Wechselsignalanteil PAC und einer Funktion f(PDC) nur des Gleichsignalanteils PDC verwendet. Die Funktion f(PDC) kann dabei zur Reduktion der Zahl der erforderlichen Eichmessungen auch durch eine lineare oder quadratische Funktion des Gleichsignalanteils PDC als Fit-Funktion mit entsprechend angepaßten Koeffizienten angenähert werden.

**Patentansprüche**

1. Verfahren zum Messen einer elektrischen Wechselgröße (X) mit folgenden Merkmalen:

   a) es wird polarisiertes Meßlicht (L) in ein unter dem Einfluß der elektrischen Wechselgröße (X) stehendes Sensorelement (3) eingekoppelt, und die Polarisation des Meßlichts (L) wird beim Durchlaufen des Sensorelements (3) in Abhängigkeit von der elektrischen Wechselgröße (X) geändert;

b) das Meßlicht (L) wird nach Durchlaufen des Sensorelements (3) in zwei linear polarisierte Lichtteilsignale (LS1 und LS2) mit unterschiedlichen Polarisationsebenen aufgeteilt;

c) die beiden Lichtteilsignale (LS1 und LS2) werden jeweils in ein elektrisches Intensitätssignal S1 bzw. S2 umgewandelt;

d) aus diesen beiden elektrischen Intensitätssignalen S1 und S2 wird ein intensitätsnormiertes Signal

$$P = (S1-S2)/(S1+S2)$$

abgeleitet;

e) dieses intensitätsnormierte Signal P wird in seinen Wechselsignalanteil PAC und seinen Gleichsignalanteil PDC zerlegt;

f) aus dem Wechselsignalanteil PAC und dem Gleichsignalanteil PDC des intensitätsnormierten Signals P wird ein weitgehend temperaturkompensiertes Meßsignal S für die elektrische Wechselgröße (X) abgeleitet.

2. Verfahren nach Anspruch 1, bei dem das Meßsignal S aus dem Wechselsignalanteil PAC und dem Gleichsignalanteil PDC des intensitätsnormierten Signals P gemäß der Vorschrift

$$S = (a*PAC+b*\underline{1})/(c*PDC+d*\underline{1})$$

abgeleitet wird, wobei a, b, c und d reelle Koeffizienten sind mit a≠0, c≠0 und d≠0 und 1 ein Einheitssignal ist, das betragsmäßig gleich dem intensitätsnormierten Signal P ist, wenn eines der beiden Intensitätssignale S1 oder S2 verschwindet.

3. Verfahren nach Anspruch 2, bei dem die Koeffizienten a, b, c und d so eingestellt werden, daß die Temperaturabhängigkeit des Meßsignals S zumindest annähernd minimal ist.

4. Verfahren nach Anspruch 2 oder Anspruch 3, bei dem die Koeffizienten a, b, c und d im wesentlichen gemäß folgender Vorschrift eingestellt werden: a=1, b=0, c=K und d=1, wobei K ein reeller Korrekturfaktor ist.

5. Verfahren nach Anspruch 2 oder Anspruch 3, bei dem die Koeffizienten a, b, c und d gemäß folgender Vorschrift eingestellt werden: a=1, b=0, c=1 und d=K', wobei K' ein reeller Korrekturfaktor ist.

6. Verfahren nach Anspruch 1, bei dem das Meßsignal S aus dem Wechselsignalanteil PAC und dem Gleichsignalanteil PDC des intensitätsnormierten Signals P mit Hilfe einer vorab ermittelten Wertetabelle oder Eichfunktion abgeleitet wird.

7. Verfahren nach einem der Ansprüche 1 bis 6 zum Messen einer elektrischen Wechselspannung (U) oder eines elektrischen Wechselfeldes, bei dem als Sensorelement ein Pockels-Element (3") verwendet wird.

8. Verfahren nach einem der Ansprüche 1 bis 6 zum Messen eines elektrischen Wechselstromes (I) in einem Stromleiter (2), bei dem als Sensorelement ein dem Stromleiter (2) zugeordnetes Faraday-Element (3') verwendet wird.

9. Verfahren nach einem der Ansprüche 1 bis 8, bei dem linear polarisiertes Meßlicht (L) verwendet wird.

10. Verfahren nach einem der Ansprüche 1 bis 7, bei dem zirkular polarisiertes Meßlicht (L) verwendet wird.

11. Verfahren nach den Ansprüchen 4, 8 und 9, bei dem der Korrekturfaktor K und der Einkoppelwinkel η der Polarisationsebene des in das Faraday-Element (3') eingekoppelten Meßlichts (L) zu einer Eigenachse der linearen Doppelbrechung in dem Faraday-Element (3') sowie der Auskoppelwinkel θ zwischen dieser Eigenachse der linearen Doppelbrechung und einer Eigenachse eines zum Aufteilen des Meßlichts (L) in die beiden Lichtteilsignale (LS1 und LS2) vorgesehenen Analysators (7) derart eingestellt werden, daß sie wenigstens annähernd die folgenden Bedingungen erfüllen:

$$\cos(2\theta + 2\eta) = -2/(3K)$$

$$\sin(2\theta - 2\eta) = 1 .$$

12. Verfahren nach den Ansprüchen 5, 8 und 9, bei dem der Korrekturfaktor K' und der Einkoppelwinkel η der Polarisationsebene des in das Faraday-Element (3') eingekoppelen Meßlichts (L) zu einer Eigenachse der linearen Doppelbrechung in dem Faraday-Element (3') sowie der Auskoppelwinkel θ zwischen dieser Eigenachse der linearen Doppelbrechung und einer Eigenachse eines zum Aufteilen des Meßlichts (L) in die beiden Lichtteilsignale (LS1 und LS2) vorgesehenen Analysators (7) derart eingestellt werden, daß sie wenigstens annähernd die folgenden Bedingungen erfüllen:

$$\cos(2\theta + 2\eta) = -(2/3)\cdot K'$$

$$\sin(2\theta - 2\eta) = 1 .$$

13. Vorrichtung zum Messen einer elektrischen Wechselgröße (X) mit folgenden Merkmalen:

    a) es sind Mittel (4,5) vorgesehen zum Einkoppeln polarisierten Meßlichts (L) in ein unter dem Einfluß der elektrischen Wechselgröße (X) stehendes optisches Sensorelement (3), in dem die Polarisation des Meßlichts (L) in Abhängigkeit von der elektrischen Wechselgröße (X) geändert wird;
    b) es sind Mittel (7) zum Aufteilen des Meßlichts (L) nach Durchlaufen des Sensorelements (3) in zwei linear polarisierte Lichtteilsignale (LS1 und LS2) mit unterschiedlichen Polarisationsebenen vorgesehen;
    c) es sind Mittel (12 und 22) zum Umwandeln der beiden Lichtteilsignale (LS1 und LS2) in jeweils ein elektrisches Intensitätssignal S1 bzw. S2 vorgesehen;
    d) es sind Mittel (30) vorgesehen zum Ableiten eines intensitätsnormierten Signals P = (S1-S2)/(S1+S2) aus den beiden elektrischen Intensitätssignalen S1 und S2;
    e) es sind Mittel (40) zum Zerlegen dieses intensitätsnormierten Signals P in seinen Wechselsignalanteil PAC und seinen Gleichsignalanteil PDC vorgesehen;
    f) es sind Mittel (50) zum Ableiten eines weitgehend temperaturkompensierten meßsignals S für die elektrische Wechselgröße (X) aus dem Wechselsignalanteil PAC und dem Gleichsignalanteil PDC des intensitätsnormierten Signals P vorgesehen.

14. Vorrichtung nach Anspruch 13, bei der die Mittel zum Ableiten des Meßsignals S aus dem Wechselsignalanteil PAC und dem Gleichsignalanteil PDC des intensitätsnormierten Signals P eine Recheneinheit (50) umfassen, die das Meßsignal S gemäß der Vorschrift

$$S = (a*PAC+b*\underline{1})/(c*PDC+d*\underline{1})$$

ermittelt, wobei a, b, c und d reelle Koeffizienten sind mit a≠0, c≠0 und d≠0 und $\underline{1}$ ein Einheitssignal ist, das betragsmäßig gleich dem intensitätsnormierten Signal P ist, wenn eines der beiden Intensitätssignale S1 oder S2 verschwindet.

15. Vorrichtung nach Anspruch 14, bei der die Koeffizienten a, b, c und d so eingestellt sind, daß die Temperaturabhängigkeit des Meßsignals S zumindest annähernd minimal ist.

16. Vorrichtung nach Anspruch 14 oder Anspruch 15, bei der die Koeffizienten a, b, c und d gemäß folgender Vorschrift eingestellt sind: a=1, b=0, c=K und d=1, wobei K ein reeller Korrekturfaktor ist.

17. Vorrichtung nach Anspruch 14 oder Anspruch 15, bei der die Koeffizienten a, b, c und d gemäß folgender Vorschrift eingestellt sind: a=1, b=0, c=1 und d=K', wobei K' ein reeller Korrekturfaktor ist.

18. Vorrichtung nach einem der Ansprüche 13 bis 17 zum Messen einer elektrischen Wechselspannung (U) oder eines elektrischen Wechselfeldes, bei der als Sensorelement ein Pockels-Element (3") vorgesehen ist.

19. Vorrichtung nach einem der Ansprüche 13 bis 17 zum Messen eines elektrischen Wechselstromes (I), bei der als Sensorelement ein Faraday-Element (3') vorgesehen ist.

20. Vorrichtung nach einem der Ansprüche 13 bis 18, bei der die Mittel (4,5,6) zum Einkoppeln zirkular polarisiertes Meßlicht (L) in das Sensorelement (3) einkoppeln.

21. Vorrichtung nach einem der Ansprüche 13 bis 19, bei der die Mittel (4,5) zum Einkoppeln linear polarisiertes Meßlicht (L) in das Sensorelement (3) einkoppeln.

22. Vorrichtung nach den Ansprüchen 16, 19 und 21, bei der der Korrekturfaktor K und der Einkoppelwinkel η der Polarisationsebene des in das Faraday-Element (3') eingekoppelten Meßlichts (L) zu einer Eigenachse der linearen Doppelbrechung in dem Faraday-Element (3') sowie der Auskoppelwinkel θ zwischen dieser Eigenachse der linearen Doppelbrechung und einer Eigenachse eines zum Aufteilen des Meßlichts (L) in die beiden Lichtteilsignale (LS1 und LS2) vorgesehenen Analysators (7) derart eingestellt sind, daß sie wenigstens annähernd die folgenden Bedingungen erfüllen:

$$\cos(2\theta + 2\eta) = - 2/(3K)$$

$$\sin(2\theta - 2\eta) = 1 \ .$$

23. Vorrichtung nach den Ansprüchen 17, 19 und 21, bei der der Korrekturfaktor K' und der Einkoppelwinkel η der Polarisationsebene des in das Faraday-Element (3') eingekoppelen Meßlichts (L) zu einer Eigenachse der linearen Doppelbrechung in dem Faraday-Element (3') sowie der Auskoppelwinkel θ zwischen dieser Eigenachse der linearen Doppelbrechung und einer Eigenachse eines zum Aufteilen des Meßlichts (L) in die beiden Lichtteilsignale (LS1 und LS2) vorgesehenen Analysators (7) derart eingestellt sind, daß sie wenigstens annähernd die folgenden Bedingungen erfüllen:

$$\cos(2\theta + 2\eta) = - (2/3)\cdot K'$$

$$\sin(2\theta - 2\eta) = 1 \ .$$

24. Vorrichtung nach Anspruch 13, bei der die Mittel zum Ableiten des Meßsignals S aus dem Wechselsignalanteil PAC und dem Gleichsignalanteil PDC des intensitätsnormierten Signals P wenigstens einen Speicher zum Speichern einer vorab ermittelten Wertetabelle oder Eichfunktion umfassen.

## Claims

1. Method for measuring an electrical alternating quantity (X), having the following features:

   a) polarised measuring light (L) is coupled into a sensor element (3) subjected to the influence of the electrical alternating quantity (X), and the polarisation of the measuring light (L) is changed as a function of the electrical alternating quantity (X) on passing through the sensor element (3);
   b) the measuring light (L) is split into two linearly polarised partial light signals (LS1 and LS2) of different planes of polarisation after passing through the sensor element (3);
   c) the two partial light signals (LS1 and LS2) are converted into an electrical intensity signal S1 and S2 respectively;
   d) an intensity-normalised signal

   $$P = (S1-S2)/(S1+S2)$$

   is derived from these two electrical intensity signals S1 and S2;
   e) this intensity-normalised signal P is decomposed into its alternating signal component PAC and its direct signal component PDC;
   f) a substantially temperature-compensated measurement signal S for the electrical alternating quantity (X) is derived from the alternating signal component PAC and the direct signal component PDC of the intensity-normalised signal P.

2. Method according to claim 1, in which the measurement signal S is derived from the alternating signal component PAC and the direct signal component PDC of the intensity-normalised signal P according to the rule

$$S = (a*PAC+b*\underline{1})/(c*PDC+d*\underline{1})$$

a, b, c and d being real coefficients with $a \neq 0$, $c \neq 0$, and $d \neq 0$ and $\underline{1}$ being a unity signal that is equal to the intensity-normalised signal P when one of the two intensity signals S1 or S2 disappears.

3. Method according to claim 2, in which the coefficients a, b, c and d are adjusted so that the temperature dependence of the measurement signal S is at least approximately a minimum.

4. Method according to claim 2 or claim 3, in which the coefficients a, b, c and d are basically adjusted according to the following rule: a=1, b=0, c=K and d=1, K being a real correction factor.

5. Method according to claim 2 or claim 3, in which the coefficients a, b, c and d are adjusted according to the following rule: a=1, b=0, c=1 and d=K', K' being a real correction factor.

6. Method according to claim 1, in which the measurement signal S is derived from the alternating signal component PAC and the direct signal component PDC of the intensity-normalised signal P using a previously established value table or calibration function.

7. Method according to one of claims 1 to 6 for measuring an electrical alternating voltage (U) or an electrical alternating field, in which a Pockels element (3") is used as sensor element.

8. Method according to one of claims 1 to 6 for measuring an electrical alternating current (I) in a current conductor (2), in which a Faraday element (3') associated with the current conductor (2) is used as sensor element.

9. Method according to one of claims 1 to 8, in which linearly polarised measuring light (L) is used.

10. Method according to claims 1 to 7, in which circularly polarised measuring light (L) is used.

11. Method according to claims 4, 8 and 9, in which the correction factor K and the coupling angle $\eta$ of the plane of polarisation of the measuring light (L) coupled into the Faraday element (3') relative to an intrinsic axis of the linear double refraction in the Faraday element (3') and also the decoupling angle $\Theta$ between this intrinsic axis of the linear double refraction and an intrinsic axis of an analyser (7) provided to split the measuring light (L) into the two partial light signals (LS1 and LS2) are adjusted so that they satisfy at least approximately the following conditions:

$$\cos(2\Theta + 2\eta) = -2/(3K)$$

$$\sin(2\Theta - 2\eta) = 1.$$

12. Method according to claims 5, 8 and 9, in which the correction factor K' and coupling angle $\eta$ of the plane of polarisation of the measuring light (L) coupled into the Faraday element (3') relative to an intrinsic axis of the linear double refraction in the Faraday element (3') and also the decoupling angle $\Theta$ between this intrinsic axis of the linear double refraction and an intrinsic axis of an analyser (7) provided to split the measuring light (L) into two partial light signals (LS1 and LS2) are adjusted so that they satisfy at least approximately the following conditions:

$$\text{con}(2\Theta + 2\eta) = - (2/3).K'$$

$$\sin(2\Theta - 2\eta) = 1 .$$

13. Device for measuring an electrical alternating quantity (X) having the following features:

    a) means (4,5) are provided for coupling polarised measuring light (L) into an optical sensor element (3) under the influence of the electrical alternating quantity (X), in which element the polarisation of the measuring light (L) is altered as a function of the electrical alternating quantity (X);
    b) means (7) are provided for splitting the measuring light (L) after passing through the sensor element (3) into two linearly polarised partial light signals (LS1 and LS2) having different planes of polarisation;
    c) means (12 and 22) are provided for converting the two partial light signals (LS1 and LS2) into electrical intensity signals S1 and S2 respectively;
    d) means (30) are provided for deriving an intensity-normalised signal $P = (S1-S2)/(S1+S2)$ from the two electrical intensity signals S1 and S2;
    e) means (40) are provided for decomposing this intensity-normalised signal P into its alternating signal component PAC and its direct signal component PDC;

f) means (50) are provided for deriving a substantially temperature-compensated measurement signal S for the electrical alternating quantity (X) from the alternating signal component PAC and the direct signal component PDC of the intensity-normalised signal P.

14. Device according to claim 13, in which the means for deriving the measurement signal S from the alternating signal component PAC and the direct signal component PDC of the intensity-normalised signal P comprise an arithmetic unit (50) which determines the measurement signal S according to the rule

$$S = (a*PAC + b*\underline{1})/(c*PDC + d*\underline{1})$$

a, b, c and d being real coefficients where a≠0, c≠0 and d≠0 and $\underline{1}$ being a unit signal whose value is equal to the intensity-normalised signal P when one of the two intensity signals S1 or S2 disappears.

15. Device according to claim 14, in which the coefficients a, b, c and d are adjusted so that the temperature dependence of the measurement signal S is at least approximately a minimum.

16. Device according to claim 14 or claim 15, in which the coefficients a, b, c and d are adjusted according to the following rule: a=1, b=0, c=K and d=1, K being a real correction factor.

17. Device according to claim 14 or claim 15, in which the coefficients a, b, c and d are adjusted according to the following rule: a=1, b=0, c=1 and d=K', K' being a real correction factor.

18. Device according to one of claims 13 to 17 for measuring an electrical alternating voltage (U) or an electrical alternating field, in which a Pockels element (3") is provided as sensor element.

19. Device according to one of claims 13 to 17 for measuring an electrical alternating current (I), in which a Faraday element (3') is provided as sensor element.

20. Device according to one of claims 13 to 18, in which the coupling means (4, 5, 6) couple circularly polarised measuring light (L) into the sensor element (3).

21. Device according to one of claims 13 to 19, in which the coupling means (4, 5) couple linearly polarised measuring light (L) into the sensor element (3).

22. Device according to claims 16, 19 and 21, in which the correction factor K and the coupling angle η of the plane of polarisation of the measuring light (L) coupled into the Faraday element (3') relative to an intrinsic axis of the linear double refraction in the Faraday element (3') and also the decoupling angle Θ between this intrinsic axis of the linear double refraction and an intrinsic axis of an analyser (7) provided to split the measuring light (L) into the two partial light signals (LS1 and LS2) are adjusted so that they satisfy at least approximately the following conditions:

$$\cos(2\Theta + 2\eta) = -2/(3K)$$

$$\sin(2\Theta - 2\eta) = 1 .$$

23. Device according to claims 17, 19 and 21, in which the correction factor K' and the coupling angle η of the plane of polarisation of the measuring light (L) coupled into the Faraday element (3') relative to an intrinsic axis of the linear double refraction in the Faraday element (3') and also the coupling angle Θ between this intrinsic axis of the linear double refraction and an intrinsic axis of an analyser (7) provided to split the measuring light (L) into the two partial light signals (LS1 and LS2) are adjusted so that they satisfy at least approximately the following conditions:

$$\cos(2\Theta + 2\eta) = -(2/3) . K'$$

$$\sin(2\Theta - 2\eta) = 1 .$$

24. Device according to claim 13, in which the means for deriving the measurement signal S from the alternating signal component PAC and the direct signal component PDC of the intensity-normalised signal P comprise at least a memory for storing a previously established value table or calibration function.

**Revendications**

1. Procédé destiné à la mesure d'une grandeur électrique alternative (X), présentant les particularités suivantes :

a) on couple de la lumière (L) de mesure polarisée dans un élément (3) de détection soumis à l'influence de la grandeur électrique alternative (X), et on modifie la polarisation de la lumière (L) de mesure lors du passage dans l'élément (3) de détection en fonction de la grandeur électrique alternative (X) ;

b) après la traversée de l'élément (3) de détection, on divise la lumière (L) de mesure en deux signaux lumineux partiels (LS1 et LS2) de polarisation rectiligne dont les plans de polarisation sont différents ;

c) on convertit chacun des deux signaux lumineux partiels (LS1 et LS2) en un signal S1 ou S2 d'intensité électrique ;

d) on obtient à partir de ces deux signaux S1 et S2 d'intensité électrique, un signal d'intensité normalisée

$$P = (S1 - S2) / (S1 + S2) \ ;$$

e) on décompose ce signal P d'intensité normalisée en une composante PAC alternative de signal et en une composante PDC continue de signal ;

f) on obtient à partir de la composante PAC alternative et de la composante PDC continue du signal P d'intensité normalisée, un signal de mesure S pour la grandeur électrique alternative (X), qui est largement compensé en température.

2. Procédé selon la revendication 1, dans lequel on obtient le signal de mesure S à partir de la composante PAC alternative et de la composante PDC continue du signal P d'intensité normalisée selon la prescription

$$S = (a * PAC + b * \underline{1}) / (c * PDC + d * \underline{1})$$

a, b, c et d étant des coefficients réels avec a ≠ 0, c ≠ 0 et d ≠ 0, et $\underline{1}$ étant un signal unité dont le module est égal au signal P d'intensité normalisée lorsque l'un des deux signaux S1 ou S2 d'intensité disparaît.

3. Procédé selon la revendication 2, dans lequel que les coefficients a, b, c et d sont réglés de telle sorte que la dépendance du signal de mesure S vis-à-vis de la température soit au moins approximativement minimale.

4. Procédé selon la revendication 2 ou 3, dans lequel les coefficients a, b, c, et d sont pour l'essentiel réglés selon la prescription suivante : a = 1, b = 0, c = K et d = 1, K étant un facteur de correction réel.

5. Procédé selon la revendication 2 ou 3, dans lequel les coefficients a, b, c, et d sont réglés selon la prescription suivante : a = 1, b = 0, c = 1 et d = K', K' étant un facteur de correction réel.

6. Procédé selon la revendication 1, dans lequel on obtient le signal de mesure S à partir de la composante PAC alternative et de la composante PDC continue du signal P d'intensité normalisée à l'aide d'un tableau de valeurs ou d'une fonction d'étalonnage déterminés au préalable.

7. Procédé selon l'une quelconque des revendications 1 à 6, destiné à la mesure d'une tension électrique alternative (U) ou d'un champ électrique alternatif, dans lequel on utilise un élément (3") de Pockels comme élément de détection.

8. Procédé selon l'une quelconque des revendications 1 à 6, destiné à la mesure d'un courant électrique alternatif (I) dans un conducteur (2) de courant, dans lequel on utilise un élément (3') de Faraday associé au conducteur (2) de courant comme élément de détection.

9. Procédé selon l'une quelconque des revendications 1 à 8, dans lequel on utilise de la lumière (L) de mesure de polarisation rectiligne.

10. Procédé selon l'une quelconque des revendications 1 à 7, dans lequel on utilise de la lumière (L) de mesure de polarisation circulaire.

11. Procédé selon les revendications 4, 8 et 9, dans lequel on règle le facteur de correction K et l'angle η de couplage du plan de polarisation de la lumière (L) de mesure couplée dans l'élément (3') de Faraday par rapport à un axe intrinsèque de la biréfringence linéaire dans l'élément (3') de Faraday, ainsi que l'angle θ de découplage entre cet axe intrinsèque de la biréfringence linéaire et un axe intrinsèque d'un analyseur (7) prévu pour diviser la lumière (L) de mesure en les deux signaux lumineux partiels (LS1 et LS2), de telle sorte qu'ils remplissent au moins approximativement les conditions suivantes :

$$\cos(2\theta + 2\eta) = -2 / (3K)$$

$$\sin(2\theta - 2\eta) = 1.$$

12. Procédé selon les revendications 5, 8 et 9, dans lequel on règle le facteur de correction K' et l'angle η de couplage du plan de polarisation de la lumière (L) de mesure couplée dans l'élément (3') de Faraday par rapport à un axe intrinsèque de la biréfringence linéaire dans l'élément (3') de Faraday, ainsi que l'angle θ de découplage entre cet axe intrinsèque de la biréfringence linéaire et un axe intrinsèque d'un analyseur (7) prévu pour diviser la lumière (L) de mesure en les deux signaux lumineux partiels (LS1 et LS2), de telle sorte qu'ils remplissent au moins approximativement les conditions suivantes :

$$\cos(2\theta + 2\eta) = -(2/3) \,.\text{K}'$$

$$\sin(2\theta - 2\eta) = 1.$$

13. Dispositif de mesure d'une grandeur électrique alternative (X), présentant les particularités suivantes

a) des moyens (4, 5) sont prévus pour coupler de la lumière (L) de mesure polarisée dans un élément (3) de détection optique soumis à l'influence de la grandeur électrique alternative (X), dans lequel la polarisation de la lumière (L) de mesure est modifiée en fonction de la grandeur électrique alternative (X) ;
b) des moyens (7) sont prévus pour décomposer la lumière (L) de mesure après le passage de l'élément (3) de détection en deux signaux lumineux partiels (LS1 et LS2) de polarisation rectiligne dont les plans de polarisation sont différents ;
c) des moyens (12 et 22) sont prévus pour convertir les deux signaux lumineux partiels (LS1 et LS2) en un signal (S1 ou S2) d'intensité électrique ;
d) des moyens (30) sont prévus pour obtenir un signal P = (S1 - S2) / (S1 + S2) d'intensité normalisée à partir des deux signaux S1 et S2 d'intensité électrique ;
e) des moyens (40) sont prévus pour décomposer ce signal P d'intensité normalisée en sa composante PAC alternative de signal et en sa composante PDC continue de signal ;
f) des moyens (50) sont prévus pour obtenir à partir de la composante PAC alternative et de la composante PDC continue du signal P d'intensité normalisée un signal de mesure S pour la grandeur électrique alternative (X), qui est largement compensé en température .

14. Dispositif selon la revendication 13, dans lequel les moyens destinés à obtenir le signal de mesure S à partir de la composante PAC alternative et de la composante PDC continue du signal P d'intensité normalisée comportent une unité (50) de calcul, qui détermine le signal de mesure S selon la prescription

$$S = (a * PAC + b * \underline{1}) / (c * PDC + d * \underline{1})$$

a, b, c et d étant des coefficients réels avec a ≠ 0, c ≠ 0 et d ≠ 0, et $\underline{1}$ étant un signal unité dont le module est égal au signal P d'intensité normalisée lorsque l'un des deux signaux S1 ou S2 d'intensité disparaît.

15. Dispositif selon la revendication 14, dans lequel les coefficients a, b, c et d sont réglés de telle sorte que la dépendance du signal de mesure S vis-à-vis de la température soit au moins approximativement minimale.

16. Dispositif selon la revendication 14 ou 15, dans lequel les coefficients a, b, c, et d sont réglés selon la prescription suivante : a = 1, b = 0, c = K et d = 1, K étant un facteur de correction réel.

17. Dispositif selon la revendication 14 ou 15, dans lequel les coefficients a, b, c, et d sont réglés selon la prescription suivante : a = 1, b = 0, c = 1 et d = K', K' étant un facteur de correction réel.

18. Dispositif selon l'une quelconque des revendications 13 à 17 destiné à la mesure d'une tension électrique alternative (U) ou d'un champ électrique alternatif, dans lequel un élément (3") de Pockels est prévu comme élément de détection.

19. Dispositif selon l'une quelconque des revendications 13 à 17 destiné à la mesure d'un courant électrique alternatif (I), dans lequel un élément (3') de Faraday est prévu comme élément de détection.

20. Dispositif selon l'une quelconque des revendications 13 à 18, dans lequel les moyens (4, 5, 6) de couplage couplent de la lumière (L) de mesure de polarisation circulaire dans l'élément (3) de détection.

21. Dispositif selon l'une quelconque des revendications 13 à 19, dans lequel les moyens (4, 5) de couplage couplent de la lumière (L) de mesure de polarisation rectiligne dans l'élément (3) de détection.

22. Dispositif selon les revendications 16, 19 et 21, dans lequel on règle le facteur de correction K et l'angle η de couplage du plan de polarisation de la lumière (L) de mesure couplée dans l'élément (3') de Faraday par rapport à un axe intrinsèque de la biréfringence linéaire dans l'élément (3') de Faraday, ainsi que l'angle θ de découplage entre cet axe intrinsèque de la biréfringence linéaire et un axe intrinsèque d'un analyseur (7) prévu pour diviser la lumière (L) de mesure en les deux signaux lumineux partiels (LS1 et LS2), de telle sorte qu'ils remplissent au moins approximativement les conditions suivantes :

$$\cos(2\theta + 2\eta) = -2 / (3K)$$

$$\sin(2\theta - 2\eta) = 1.$$

**23.** Dispositif selon les revendications 17, 19 et 21, dans lequel on règle le facteur de correction K' et l'angle η de couplage du plan de polarisation de la lumière (L) de mesure couplée dans l'élément (3') de Faraday par rapport à un axe intrinsèque de la biréfringence linéaire dans l'élément (3') de Faraday, ainsi que l'angle θ de découplage entre cet axe intrinsèque de la biréfringence linéaire et un axe intrinsèque d'un analyseur (7) prévu pour diviser la lumière (L) de mesure en les deux signaux lumineux partiels (LS1 et LS2), de telle sorte qu'ils remplissent au moins approximativement les conditions suivantes :

$$\cos(2\theta + 2\eta) = -(2/3) \cdot K'$$

$$\sin(2\theta - 2\eta) = 1.$$

**24.** Dispositif selon la revendication 13, dans lequel les moyens destinés à obtenir le signal de mesure S à partir de la composante PAC alternative et de la composante PDC continue du signal P d'intensité normalisée comportent au moins une mémoire pour mémoriser un tableau de valeurs ou une fonction d'étalonnage déterminés au préalable.

FIG 1

FIG 2

FIG 3

EP 0 721 589 B1

PAC        PDC

K' * 1

ADD
52

50

DIV
53

S

FIG 4

PAC        PDC

* K
54

1

ADD
55

DIV
57

50

S

FIG 5

FIG 6

FIG 7

$$P = (S1 - S2)/(S1 + S2)$$

FIG 8